# EUROPEAN PATENT APPLICATION

(11) **EP 4 679 988 A1**
(43) Date of publication of application: **14.01.2026**
(21) Application number: 25187958.1
(22) Date of filing: 07.07.2025
(51) Int. Cl.: H10K 59/12, H10K 59/131, H10K 59/80, H10K 71/50, H10K 71/70

(54) **DISPLAY DEVICE, METHOD FOR MANUFACTURING THE DISPLAY DEVICE, AND ELECTRONIC APPARATUS INCLUDING THE DISPLAY DEVICE**

(30) Priority: 10.07.2024 KR 20240091093
(71) Applicant: Samsung Display Co., Ltd., Yongin-si, Gyeonggi-do (KR)
(72) Inventor: LEE, Seungmin, Yongin-si (KR); HONG, Seungwan, Yongin-si (KR); HWANG, Soukjune, Yongin-si (KR)
(74) Representative: Marks & Clerk LLP

(57) **Abstract**

A display device includes a first substrate, an insulating layer, a line, a pixel defining film, a first electrode, a second electrode, an emission layer, a metal layer, a first pattern part, and a second pattern part. The first substrate is divided into an active area and a peripheral area adjacent to the active area. The first pattern part includes a first portion of a line, a second portion of a metal layer, and a third portion of a second electrode and overlaps the peripheral area. The second pattern part includes a fourth portion of the line, a fifth portion of the metal layer, and a sixth portion of the second electrode and is spaced apart from an active area with the first pattern part therebetween. The display device may exhibit excellent processibility.

## Description

### BACKGROUND

The present disclosure herein relates to a display device including a filler, a method for manufacturing the display device, and an electronic apparatus including the display device.

Various display devices used in multimedia devices such as, for example, televisions, mobile phones, table computers, and game consoles are being developed. In some cases, a display device may be provided by bonding two facing substrates and include a sealing part that bonds the two substrates and a filler that fills a space between the two substrates. The filler may be provided by providing a liquid composition, and when a degree of spread of the filler is not confirmed, poor bonding occurs, or the manufacturing process time increases.

### SUMMARY

The present disclosure provides a display device having excellent processability and an electronic apparatus including the same.

The present disclosure also provides a method for manufacturing a display having excellent manufacturing efficiency.

An embodiment of the inventive concept provides a display device including: a first substrate that is divided into an active area and a peripheral area adjacent to the active area; an insulating layer overlapping the active area and the peripheral area and disposed on the first substrate; a line overlapping the peripheral area and disposed on the first substrate; a pixel defining film in which a plurality of openings including a first sub-opening through a third sub-opening are defined and which is disposed on the insulating layer; a first electrode exposed through the first sub-opening, overlapping the active area, and disposed on the insulating layer; a second electrode extending from the active area to the peripheral area and disposed on the first electrode; an emission layer overlapping the active area and disposed between the first electrode and the second electrode; a metal layer exposed through the second sub-opening and the third sub-opening, overlapping the peripheral area, and disposed on the insulating layer; a first pattern part including a first portion of the line, a second portion of the metal layer, and a third portion of the second electrode and overlapping the peripheral area; and a second pattern part including a fourth portion of the line, a fifth portion of the metal layer, and a sixth portion of the second electrode and spaced apart from the active area, wherein the first pattern part is between the active area and each of the fourth portion of the line, the fifth portion of the metal layer, and the sixth portion of the second electrode.

In an embodiment, the display device may further include: a second substrate disposed on the pixel defining film; a sealing part disposed between the first substrate and the second substrate and overlapping the peripheral area; and a filler configured to fill an internal space defined by the first substrate, the second substrate, and the sealing part.

In an embodiment, the display device element may further include a capping layer extending from the active area to the peripheral area and disposed on the second electrode, wherein the first pattern part may further include a seventh portion of the capping layer, and the second pattern part may further include an eighth portion of the capping layer.

In an embodiment, in a direction perpendicular to a thickness direction, the first pattern part and the second pattern part may be spaced apart from each other, and the insulating layer is between the first pattern part and the second pattern part.

In an embodiment, the line may include a first sub-line and a second sub-line disposed on the first sub-line.

In an embodiment, a plurality of insulating openings including a first auxiliary opening and a second auxiliary opening may be defined in the insulating layer, the first pattern part may be disposed within the first auxiliary opening, and the second pattern part may be disposed within the second auxiliary opening.

In an embodiment, the first auxiliary opening of the insulating layer may overlap the second sub-opening of the pixel defining film, and in a direction perpendicular to a thickness direction, a first width of the first auxiliary opening may be less than a second width of the second sub-opening.

In an embodiment, the second auxiliary opening of the insulating layer may overlap the third sub-opening of the pixel defining film, and in a direction perpendicular to a thickness direction, a third width of the second auxiliary opening may be less than a fourth width of the third sub-opening.

In an embodiment, the insulating layer may include an organic material.

In an embodiment, the first electrode and the metal layer may include the same material.

In an embodiment, the metal layer may include at least one selected from materials including Ag, Mg, Cu, Al, Pt, Pd, Au, Ni, Nd, Ir, Cr, Li, Ca, Mo, Ti, W, In, Zn, Sn, and Yb, two or more compounds selected from the materials, a mixture of two or more selected from the materials, or at least one selected from oxides of the materials.

In an embodiment, the display device may further include a pad electrically connected to the line and overlapping the peripheral area.

In an embodiment, on a plane perpendicular to a thickness direction, at least a portion of the first pattern part and the second pattern part may be spaced apart from the pad.

In an embodiment, the display device may further include a sub-insulating layer disposed between the first substrate and the insulating layer, wherein the sub-insulating layer may include an inorganic material.

In an embodiment, the line may be disposed on the sub-insulating layer.

In an embodiment, on a plane perpendicular to a thickness direction, each of the first pattern part and the second pattern part may be disposed surrounding a portion of the active area.

In an embodiment of the inventive concept, a method for manufacturing a display device includes: preparing a second substrate; forming a preliminary filler by providing a composition onto the second substrate; providing a display panel on the preliminary filler; inspecting the preliminary filler; and forming a filler by curing the preliminary filler, wherein the display panel includes: a first substrate that is divided into an active area and a peripheral area adjacent to the active area; an insulating layer overlapping the active area and the peripheral area and disposed on the first substrate; a line overlapping the peripheral area and disposed on the first substrate; a pixel defining film in which a plurality of openings including a first sub-opening through a third sub-opening are defined and which is disposed on the insulating layer; a first electrode exposed through the first sub-opening, overlapping the active area, and disposed on the insulating layer; a second electrode extending from the active area to the peripheral area and disposed on the first electrode; an emission layer overlapping the active area and disposed between the first electrode and the second electrode; a metal layer exposed through the second sub-opening and the third sub-opening, overlapping the peripheral area, and disposed on the insulating layer; a first pattern part including a first portion of the line, a second portion of the metal layer, and a third portion of the second electrode and overlapping the peripheral area; and a second pattern part including a fourth portion of the line, a fifth portion of the metal layer, and a sixth portion of the second electrode and spaced apart from the active area, wherein the first pattern part is between the active area and each of the fourth portion of the line, the fifth portion of the metal layer, and the sixth portion of the second electrode, wherein the inspecting of the preliminary filler includes comparing light transmittance of the first pattern part and light transmittance of the second pattern part with each other.

In an embodiment, the composition may be provided in a dispensing method.

In an embodiment, the method may further include, before the forming of the preliminary filler, providing a preliminary sealing part on an area of the second substrate, which overlaps the peripheral area, and forming a sealing part from the preliminary sealing part, wherein forming the sealing part from the preliminary sealing part may be performed between the providing of the display panel and the forming of the filler.

In an embodiment, the filler may fill an internal space defined by the first substrate, the second substrate, and the sealing part.

In an embodiment, the first electrode and the metal layer may include the same material.

In an embodiment, the metal layer may include at least one selected from materials including Ag, Mg, Cu, Al, Pt, Pd, Au, Ni, Nd, Ir, Cr, Li, Ca, Mo, Ti, W, In, Zn, Sn, and Yb, two or more compounds selected from the materials, a mixture of two or more selected from the materials, or oxides of the materials.

In an embodiment of the inventive concept, an electronic apparatus includes: a display device, on which a sensing area is defined; and an electronic module disposed corresponding to the sensing area, wherein the display device includes: a first substrate that is divided into an active area and a peripheral area adjacent to the active area; an insulating layer overlapping the active area and the peripheral area and disposed on the first substrate; a line overlapping the peripheral area and disposed on the first substrate; a pixel defining film in which a plurality of openings including a first sub-opening through a third sub-opening are defined and which is disposed on the insulating layer; a first electrode exposed through the first sub-opening, overlapping the active area, and disposed on the insulating layer; a second electrode extending from the active area to the peripheral area and disposed on the first electrode; an emission layer overlapping the active area and disposed between the first electrode and the second electrode; a metal layer exposed through the second sub-opening and the third sub-opening, overlapping the peripheral area, and disposed on the insulating layer; a first pattern part including a first portion of the line, a second portion of the metal layer, and a third portion of the second electrode and overlapping the peripheral area; and a second pattern part including a fourth portion of the line, a fifth portion of the metal layer, and a sixth portion of the second electrode and spaced apart from the active area, wherein the first pattern part is between the active area and each of the fourth portion of the line, the fifth portion of the metal layer, and the sixth portion of the second electrode.

In an embodiment, the display device may further include: a second substrate disposed on the pixel defining film; a sealing part disposed between the first substrate and the second substrate and overlapping the peripheral area; and a filler configured to fill an internal space defined by the first substrate, the second substrate, and the sealing part.

In an embodiment, the display device may further include a capping layer extending from the active area to the peripheral area and disposed on the second electrode, the first pattern part may further include a seventh portion of the capping layer, and the second pattern part may further include an eighth portion of the capping layer.

In an embodiment, in a direction perpendicular to a thickness direction, the first pattern part and the second pattern part may be spaced apart from each other, and the insulating layer may be between the first pattern part and the second pattern part.

In an embodiment, the first electrode and the metal layer may include the same material.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a perspective view of an electronic apparatus according to an embodiment of the inventive concept;
FIG. 2 is an exploded perspective view of the electronic apparatus according to an embodiment of the inventive concept;
FIG. 3 is a cross-sectional view taken along line I-I' of FIG. 2;
FIG. 4 is a plan view illustrating a portion of the display device according to an embodiment of the inventive concept;
FIG. 5 is an enlarged cross-sectional view of an area AA' of FIG. 3;
FIG. 6A is an enlarged cross-sectional view of an area XX' of FIG. 3;
FIG. 6B is a cross-sectional view illustrating a portion of the display device according to an embodiment of the inventive concept;
FIG. 7 is a plan view illustrating a portion of the display device according to an embodiment of the inventive concept;
FIG. 8 is a flowchart illustrating a method for manufacturing a display device according to an embodiment of the inventive concept;
FIG. 9 is a schematic view illustrating the method for manufacturing the display device according to an embodiment of the inventive concept;
FIG. 10 is a schematic view illustrating the method for manufacturing the display device according to an embodiment of the inventive concept;
FIG. 11 is a schematic view illustrating the method for manufacturing the display device according to an embodiment of the inventive concept; and
FIG. 12 is a schematic view illustrating the method for manufacturing the display device according to an embodiment of the inventive concept.

### DETAILED DESCRIPTION

Since the present disclosure may have diverse modified embodiments, specific embodiments are illustrated in the drawings and are described in the detailed description of the inventive concept. However, this does not limit the present disclosure within specific embodiments and it should be understood that the present disclosure covers all the modifications, equivalents, and replacements within the idea and technical scope of the present disclosure.

In this specification, it will also be understood that when one component (or region, layer, portion) is referred to as being 'on', 'connected to', or 'coupled to' another component, it can be directly disposed/connected/coupled on/to the one component, or an intervening third component may also be present.

Like reference numerals refer to like elements throughout. In the figures, the thickness, ratio, and dimensions of components are exaggerated for clarity of illustration. The term "and/or" includes any and all combinations of one or more of the associated components.

It will be understood that although the terms such as, for example, 'first' and 'second' are used herein to describe various elements, these elements should not be limited by these terms. The terms are used to distinguish one component from other components. For example, a first element referred to as a first element in an embodiment can be referred to as a second element in another embodiment without departing from the scope of the appended claims. The terms of a singular form may include plural forms unless referred to the contrary.

The terms "under", "below", "above', "upper", and the like are used for explaining relation association of components illustrated in the drawings. The terms may be a relative concept and described based on directions expressed in the drawings.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel. The term "substantially include" means approximately or actually include.

The term "adjacent" herein may refer to elements which are relatively close to each other (e.g., within a target distance). In some other cases, the term "adjacent" herein may refer to elements which are in contact with each other. In some cases, the term "adjacent" herein may refer to elements relatively close to each other, in which another element is not disposed between the elements.

The meaning of 'include' or 'comprise' specifies a property, a fixed number, a step, an operation, an element, a component or a combination thereof, but does not exclude other properties, fixed numbers, steps, operations, elements, components or combinations thereof.

Unless otherwise defined, all terms (including technical and scientific terms) used herein have the same meaning as commonly understood by a person of ordinary skill in the art to which this invention belongs. Terms such as those defined in commonly used dictionaries should be interpreted as having meanings consistent with their meanings in the context of the relevant technology, and unless explicitly defined, it should not be interpreted in an overly idealistic or overly formal sense.

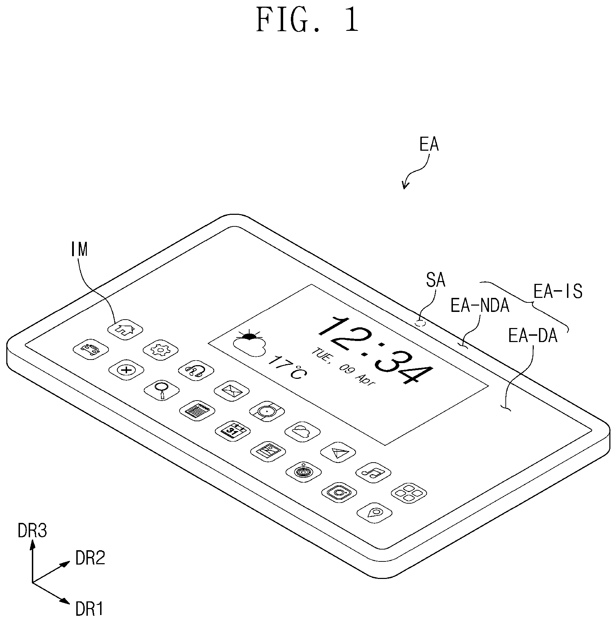

Hereinafter, embodiments of the inventive concept will be described with reference to the accompanying drawings. FIG. 1 is a perspective view of an electronic apparatus EA according to an embodiment of the inventive concept.

Referring to FIG. 1, an electronic apparatus EA may be an apparatus that is activated according to an electrical signal. For example, an electronic apparatus EA may be a medium or large apparatus such as, for example, a television, a monitor, an outdoor billboard, a tablet, or an automotive navigation unit. In some aspects, the electronic apparatus EA may be a small or medium-sized apparatus such as, for example, a personal computer, a notebook computer, a personal digital assistant, a game machine, a smart phone, and a camera. The described devices are provided as example embodiments, and thus, the electronic apparatus EA may be adopted for other electronic apparatuses unless departing from the scope of the invention.

The electronic apparatus EA may display an image IM through a display surface EA-IS. The image IM may include a still image as well as a dynamic image. The display surface EA-IS may be parallel to a plane defined by a first directional axis DR1 and a second directional axis DR2. FIG. 1 illustrates the electronic apparatus EA having the flat display surface EA-IS, but embodiments of the present disclosure are not limited thereto. The electronic apparatus EA may include a curved display surface or a three-dimensional display surface. The solid display surface may include a plurality of display areas that indicate different directions.

The display surface EA-IS may include a display area EA-DA and a non-display area EA-NDA. The electronic apparatus EA may display the image IM through the display area EA-DA. The non-display area EA-NDA may be adjacent to the display area EA-DA. The non-display area EA-NDA may surround the display area EA-DA. FIG. 1 is an example, and the non-display area EA-NDA may be disposed adjacent to a single side of the display area EA-DA or may be omitted.

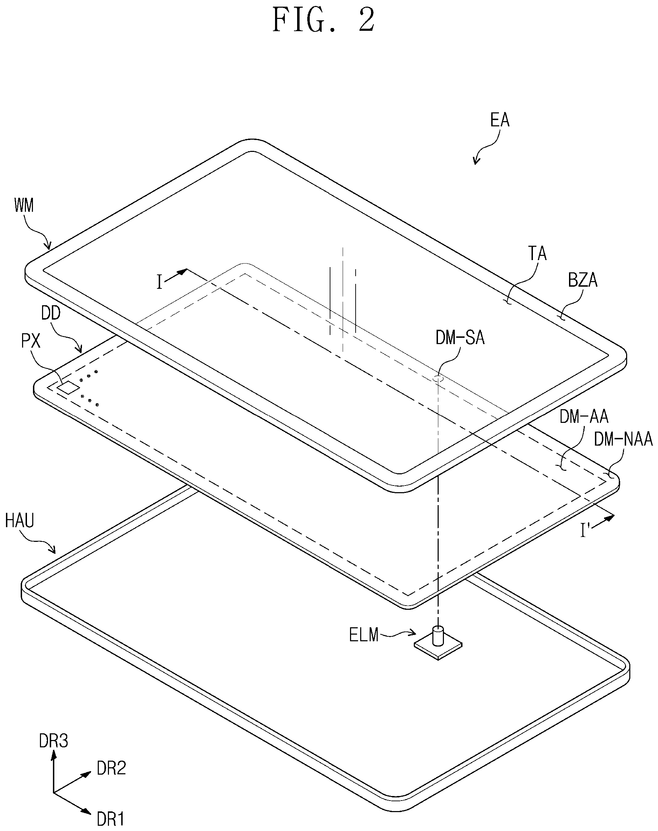

The display surface EA-IS may further include a sub-area SA. The sub-area SA may be a portion of the non-display area EA-NDA. Alternatively, the sub-area SA may be a portion of the display area EA-DA. An optical signal, for example, visible light or infrared light may move to the sub-area SA. The electronic apparatus EA may include an electronic module ELM (see FIG. 2) that captures external images using visible light passing through the sub-area SA or determines accessibility of an external object through infrared light. In FIG. 1, one sub-area SA is illustrated as an example, but embodiments of the present disclosure are not limited thereto. For example, the sub-area SA may be provided in plurality.

In FIG. 1 and following drawings, first to third directional axes DR1 to DR3 are illustrated, and directions indicated by the first to third directional axes DR1, DR2, and DR3, which are described in this specification, may be converted to other directions as a relative concept. In some aspects, the directions indicated by the first to third directional axes DR1, DR2, and DR3 may be described as first to third directions, and also the same reference numerals may be used. In this specification, the first directional axis DR1 and the second directional axis DR2 may be perpendicular to each other. A third directional axis DR3 may be a normal direction with respect to a plane defined by the first direction DR1 and the second direction DR2.

A thickness direction of the electronic apparatus EA may be parallel to the third directional axis DR3. An upper side (or top surface) and a lower side (or bottom surface) may be defined based on the third directional axis DR3. The upper side (or top surface) may refer to a direction (or surface) approaching the display surface EA-IS, and the lower side (or bottom surface) may refer to a direction (or surface) that is away from the display surface EA-IS. A cross-section may refer to a surface parallel to the thickness direction DR3, and the plane may refer to a surface perpendicular to the thickness direction DR3. The plane may refer to a plane defined by the first directional axis DR1 and the second directional axis DR2.

In this specification, overlapping of one component and the other component is not limited to a case in which the one component and the other component have the same shape and the same area, and may also include a case in which the components have different shapes and/or different areas. In this specification, the fact that one component is disposed/formed directly on another component means that a third component is not disposed/formed between one component and the other component. That is, the fact that one component is disposed/formed directly on another component means that one component is in contact with another component.

FIG. 2 is an exploded perspective view of the electronic apparatus EA according to an embodiment of the inventive concept. The electronic apparatus EA may include a display device DD, an electronic module ELM, and a window member WM disposed on the display device DD. In some aspects, the electronic apparatus EA may further include a housing HAU.

The window member WM may cover the entire outer side of the electronic apparatus EA. The window member WM may include a transmission area TA and a bezel area BZA. The front surface of the window member WM including a transmission area TA and a bezel area BZA may correspond to the front surface of the electronic apparatus EA. The transmission area TA may correspond to the display area EA-DA of the electronic apparatus EA illustrated in FIG. 1, and the bezel area BZA may correspond to the non-display area EA-NDA of the electronic apparatus EA illustrated in FIG. 1.

The transmission area TA may be an optically transparent area. The bezel area BZA may be an area having light transmittance that is relatively less than a light transmittance of the transmission area TA. The bezel area BZA may have a predetermined color. The bezel area BZA may be disposed adjacent to the transmission area TA to surround the transmission area TA. The bezel area BZA may define a shape of the transmission area TA. However, embodiments of the present disclosure are not limited to the examples illustrated herein, and the bezel area BZA may be disposed adjacent to a single side of the transmission area TA, or a portion of the bezel area BZA may be omitted.

The housing HAU may include a material having relatively high rigidity. For example, the housing HAU may include a frame and/or plate formed of glass, plastic, or a metal. The frame and/or plate may be provided in plurality. The housing HAU may provide a predetermined accommodation space. The display device DD may be accommodated within an accommodation space and protected from an external impact.

The display device DD may be configured to generate an image and sense an externally applied input. The display device DD may have an active area DM-AA and a peripheral area DM-NAA. In some aspects, a sensing area DM-SA may be defined in the display device DD. The active area DM-AA may overlap the display area EA-DA illustrated in FIG. 1, and the peripheral area DM-NAA may overlap the non-display area EA-NDA illustrated in FIG. 1. The sensing area DM-SA may overlap a sub-area SA illustrated in FIG. 1.

The active area DM-AA may be an area that is activated by an electrical signal. The peripheral area DM-NAA may be an area disposed adjacent to at least one side of the active area DM-AA. The peripheral area DM-NAA may be disposed such that the peripheral area DM-NAA surrounds the active area DM-AA. However, embodiments of the present disclosure are not limited thereto, and a portion of the peripheral area DM-NAA may be omitted, unlike the embodiment that is illustrated. Driving circuits or driving lines that drive the active area DM-AA may be disposed on the peripheral area DM-NAA.

A plurality of pixels PX may be disposed on the active area DM-AA. The plurality of pixels PX may include a red pixel, a green pixel, and a blue pixel, and, in an embodiment, the plurality of pixels PX may further include a white pixel.

The electronic module ELM may be disposed to correspond to the sensing area DM-SA. The electronic module ELM may be an electronic component that outputs or receives an optical signal. The electronic module ELM may include a camera module and/or a proximity sensor. The camera module may capture an external image through the sensing area DM-SA.

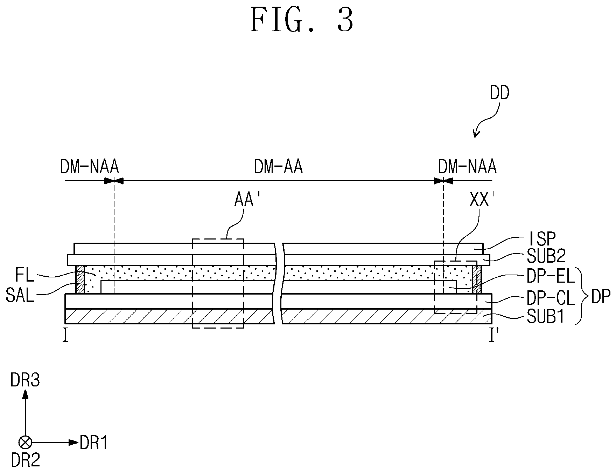

FIG. 3 is a cross-sectional view taken along line I-I' of FIG. 2. FIG. 3 is a cross-sectional view of the display device DD according to an embodiment of the inventive concept.

The display device DD may include a display panel DP and an input sensing part ISP disposed on the display panel DP. The display panel DP may be a configuration that actually generates an image. In some aspects, the display device DD may further include a second substrate SUB2, a sealing part SAL, and a filler FL. The display panel DP may include a first substrate SUB1, a circuit layer DP-CL disposed on the first substrate SUB1, and a display element layer DP-EL disposed on the circuit layer DP-CL.

The first substrate SUB1 is divided into an active area DM-AA and a peripheral area DM-NAA. The first substrate SUB1 may provide a base surface on which the circuit layer DP-CL is disposed. The first substrate SUB1 may be a glass substrate, a metal substrate, or a polymer substrate. However, embodiments of the present disclosure are not limited thereto, and the first substrate SUB1 may include an inorganic layer, an organic layer, or a composite material layer. The first substrate SUB1 may be a rigid substrate. Alternatively, the first substrate SUB1 may be a flexible substrate that is bendable, foldable, rollable, or the like.

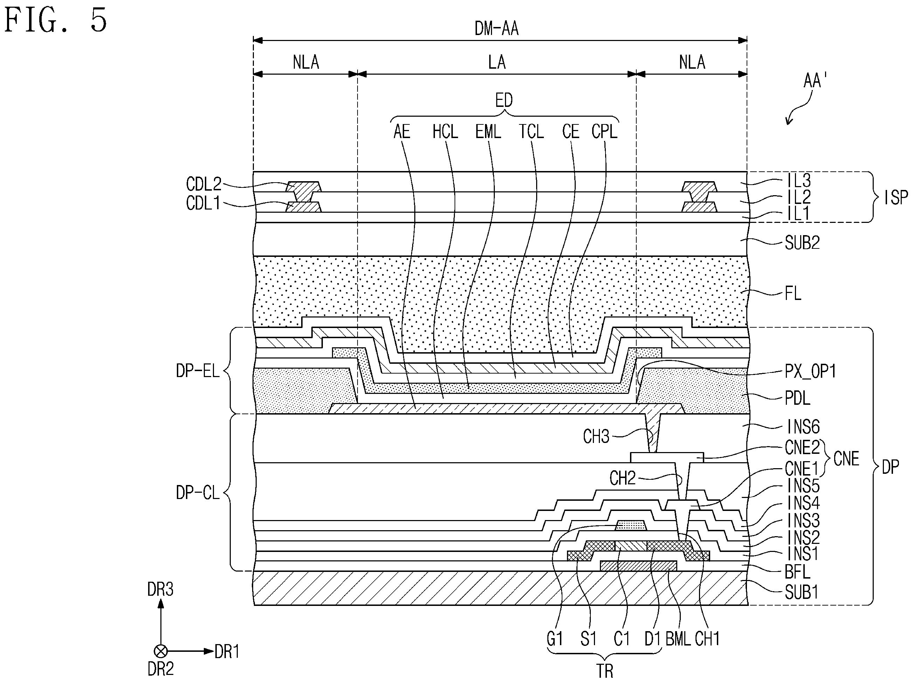

The circuit layer DP-CL may include an insulating layer, a semiconductor pattern, a conductive pattern, and a signal line. For example, the circuit layer DP-CL may include a switching transistor and a driving transistor for driving a light emitting element ED (see FIG. 5) of the display element layer DP-EL.

The display element layer DP-EL may include the light emitting element ED (see FIG. 5) described later. For example, the light emitting element ED (see FIG. 5) may include a micro LED or a nano LED. The light emitting element ED (see FIG. 5) may include an organic light emitting material, an inorganic light emitting material, an organic-inorganic light emitting material, a quantum dot, or a quantum rod.

The input sensing part ISP may sense an external input, change the external input into a predetermined input signal, and provide the input signal to the display panel DP. For example, in the display device DD according to an embodiment, the input sensing part ISP may be a touch sensing part that senses a touch. The input sensing part ISP may recognize a direct touch of a user, an indirect touch of the user, a direct touch of an object, or an indirect touch of the object.

The input sensing part ISP may sense at least one of a position or intensity (a pressure) of touch applied from the outside. In an embodiment, input sensing part ISP may have various structures or be formed of various materials, but is not limited to any one embodiment. For example, the input sensing part ISP may sense an external input in a capacitive manner. The display panel DP may receive an input signal from the input sensing part ISP to generate an image corresponding to the input signal.

The second substrate SUB2 may be disposed on a pixel defining film PDL. The second substrate SUB2 may be disposed between the display panel DP and the input sensing part ISP. The second substrate SUB2 may be a glass substrate, a metal substrate, or a polymer substrate. However, embodiments of the present disclosure are not limited thereto, and the second substrate SUB2 may include an inorganic layer, an organic layer, or a composite material layer. The second substrate SUB2 may be an encapsulation substrate.

A sealing part SAL and a filler FL may be disposed between the first substrate SUB1 and the second substrate SUB2. The sealing part SAL may overlap the peripheral area DM-NAA. The sealing part SAL may not overlap the active area DM-AA. The sealing part SAL may be a closed ring shape surrounding the active area DM-AA on a plane. The first substrate SUB1 and the second substrate SUB2 may be bonded by the sealing part SAL. The sealing part SAL may include a thermosetting material or a photocurable material. However, this is an example, and embodiments of the present disclosure are not limited thereto.

The filler FL may be disposed such that the filler FL fills an internal space defined by the first substrate SUB1, the second substrate SUB2, and the sealing part SAL. Specifically, the filler FL may be disposed such that the filler FL fills an internal space defined by the circuit layer DP-CL disposed on a first substrate SUB1, the second substrate SUB2, and the sealing part SAL. The filler FL may overlap the active area DM-AA and the peripheral area DM-NAA. The filler FL may be disposed inside the display device DD relative to the sealing part SAL.

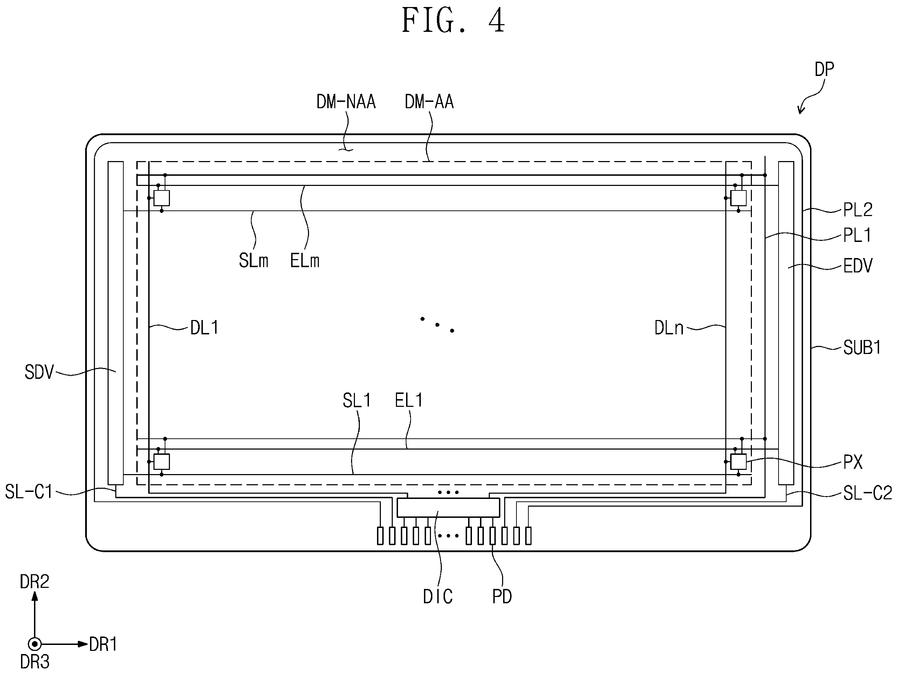

FIG. 4 is a plan view illustrating a portion of the display panel DP according to an embodiment of the inventive concept. Referring to FIG. 4, the display panel DP may include a plurality of pixels PX, a scan driving circuit SDV, an emission driving circuit EDV, a plurality of signal lines, and a plurality of pads PD. The plurality of pixels PX may be disposed on the active area DM-AA. A driving chip DIC may be mounted on the peripheral area DM-NAA. The driving chip DIC may include a data driving circuit. The data driving circuit may be integrated into the display panel DP as, for example, the scan driving circuit SDV and the emission driving circuit EDV.

The plurality of signal lines may include a plurality of scan lines SL1 to SLm, a plurality of data lines DL1 to DLn, a plurality of emission lines EL1 to ELm, a first control line SL-C1, a second control line SL-C2, a first power line PL1, and a second power line PL2. Where m and n are natural numbers of 2 or more.

The scan lines SL1 to SLm may extend in the first direction DR1 and be electrically connected to pixels PX and the scan driving circuit SDV. The data lines DL1 to DLn may extend in the second direction DR2 and be electrically connected to the pixels PX and the driving chip DIC. The emission lines EL1 to ELm may extend in the first direction DR1 and be electrically connected to the pixels PX and the emission driving circuit EDV.

The first power line PL1 may receive a first power voltage, and the second power line PL2 may receive a second power voltage having a level less than a level of the first power voltage. That is, for example, the second power voltage may be less than the first power voltage. The first power line PL1 and the second power line PL2 may be electrically connected to the pads PD, respectively. Although not illustrated, the second electrode CE (FIG. 5, e.g., cathode) of the light emitting element ED (see FIG. 5) may be electrically connected to the second power line PL2.

The first control line SL-C1 may be connected to the scan driving circuit SDV and may extend toward a lower end of the display panel DP. The second control line SL-C2 may be connected to the emission driving circuit EDV and may extend toward the lower end of the display panel DP. The pads PD may overlap the peripheral area DM-NAA. The pads PD may be disposed on the peripheral area DM-NAA adjacent to the lower end of the display panel DP and may be closer to the lower end of the display panel DP than the driving chip DIC. The pads PD may be connected to the driving chip DIC and some signal lines.

The scan driving circuit SDV may generate a plurality of scan signals, and the scan signals may be applied to the pixels PX through the scan lines SL1 to SLm. The driving chip DIC may generate a plurality of data voltages, and the data voltages may be applied to the pixels PX through the data lines DL1 to DLn. The emission driving circuit EDV may generate a plurality of emission signals, and the emission signals may be applied to the pixels PX through the emission lines EL1 to ELm. The pixels PX may receive the data voltages in response to the scan signals. The pixels PX may emit light having brightness corresponding the data voltages in response to the emission signals to display an image.

FIG. 5 is an enlarged cross-sectional view of an area AA' of FIG. 3. FIG. 5 is a detailed cross-sectional view of the active area DM-AA of the display device DD.

The first substrate SUB1 may include a single layer or multiple layers. For example, the first substrate SUB1 may include a first synthetic resin layer, a multi-layer or single-layer inorganic layer, and a second synthetic resin layer disposed on the multi-layer or single-layer inorganic layer. Each of the first synthetic resin layer and the second synthetic resin layer may include a polyimide-based resin. In some aspects, each of the first synthetic resin layer and the second synthetic resin layer may include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, or a perylene-based resin. In this specification, the "~~-based" resin means containing a "~~" functional group.

The display panel DP may include a transistor TR and a light emitting element ED. The transistor TR and the light emitting element ED may be disposed on the first substrate SUB1. Although one transistor TR is illustrated in FIG. 5, the display panel DP may substantially include a plurality of transistors and at least one capacitor for driving the light emitting element ED.

The circuit layer DP-CL may include a shielding electrode BML, a transistor TR, a connection electrode CNE, and a plurality of insulating layers BFL and INS1 to INS6. The plurality of insulating layers BFL and INS1 to INS6 may include a buffer layer BFL and first to sixth insulating layers INS1 to INS6. However, the laminated structure of the circuit layer DP-CL illustrated in FIG 5 is an example, and the laminated structure of the circuit layer DP-CL may be changed depending on the configuration of the display panel DP and the process of the circuit layer DP-CL, or other factors.

The shielding electrode BML may be disposed on the first substrate SUB1. The shielding electrode BML may overlap the transistor TR. The shielding electrode BML may protect the transistor TR by blocking light incident onto the transistor TR from a lower portion of the display panel DP. The shielding electrode BML may include a conductive material. In an example in which a voltage is applied to the shielding electrode BML, a threshold voltage of the transistor TR disposed on the shielding electrode BML may be maintained. However, embodiments of the present disclosure are not limited thereto, and the shielding electrode BML may be a floating electrode. The shielding electrode BML may be omitted.

The buffer layer BFL may be disposed on the first substrate SUB 1 and cover the shielding electrode BML. The buffer layer BFL may include an inorganic layer. The buffer layer BFL may include silicon nitride, silicon oxide, or the like. The buffer layer BFL may improve bonding strength between the semiconductor pattern or conductive pattern disposed on the buffer layer BFL and the first substrate SUB1.

The transistor TR may include a source S1, a channel C1, a drain D1, and a gate G1. The source S1, the channel C1, and the drain D1 of the transistor TR may be provided from the semiconductor pattern. The semiconductor pattern of the transistor TR may include polysilicon, amorphous silicon, or metal oxide, and if the semiconductor pattern has any semiconductor property, any materials may be applied without limitation and is not limited to any one.

The semiconductor pattern may include a plurality of regions that are distinguished by their conductivity magnitudes. A region of the semiconductor pattern, which is doped with a dopant or in which metal oxide is reduced may have high conductivity and may actually serve as source and drain electrodes of the transistor TR. A region of the semiconductor pattern, which has high conductivity, may correspond to the source S1 and the drain D1 of the transistor TR. A region of the semiconductor pattern, which is undoped or lightly doped, or in which the metal oxide is not reduced to have low conductivity, may correspond to the channel C1 (or active) of the transistor TR.

The first insulating layer INS1 may cover the semiconductor pattern of the transistor TR and may be disposed on the buffer layer BFL. The gate G1 of the transistor TR may be disposed on the first insulating layer INS1. On the plane, the gate G1 may overlap the channel C1 of the transistor TR. The gate G1 may function as a mask in the process of doping the semiconductor pattern of the transistor TR.

The second insulating layer INS2 may cover the gate G1 and may be disposed on the first insulating layer INS1. The third insulating layer INS3 may be disposed on the second insulating layer INS2.

The connection electrode CNE may include a first connection electrode CNE1 and a second connection electrode CNE2 that electrically connect the transistor TR to the light emitting element ED. However, the configuration of the connection electrode CNE that electrically connects the transistor TR to the light emitting element ED is not limited thereto, and one of the first and second connection electrodes CNE1 and CNE2 may be omitted, or an additional connection electrode may be provided.

The first connection electrode CNE1 may be disposed on the third insulating layer INS3. The first connection electrode CNE1 may be connected to the drain D1 through a first contact hole CH1 passing through the first to third insulating layers INS1 to INS3. The fourth insulating layer INS4 may cover the first connection electrode CNE1 and may be disposed on the third insulating layer INS3. The fifth insulating layer INS5 may be disposed on the fourth insulating layer INS4.

The second connection electrode CNE2 may be disposed on the fifth insulating layer INS5. The second connection electrode CNE2 may be connected to the first connection electrode CNE1 through a second contact hole CH2 passing through the fourth and fifth insulating layers INS4 and INS5. The sixth insulating layer INS6 may cover the second connection electrode CNE2 and may be disposed on the fifth insulating layer INS5.

The first to fourth insulating layers INS1 to INS4 may be inorganic layers containing an inorganic material. The fifth and sixth insulating layers INS5 and INS6 may be organic layers containing organic materials. For example, the inorganic layer may include at least one of aluminium oxide, titanium oxide, silicon nitride, silicon oxide, silicon oxynitride, zirconium oxide, or hafnium oxide. The organic layer may include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, or a perylene-based resin.

The display element layer DP-EL may include the pixel defining film PDL and the light emitting element ED. The light emitting element ED may be configured to emit light. The light emitting element ED may include a first electrode AE, a second electrode CE disposed on the first electrode AE, and an emission layer EML disposed between the first electrode AE and the second electrode CE. The light emitting element ED may further include a hole control layer HCL disposed between the first electrode AE and the emission layer EML, an electron control layer TCL disposed between the emission layer EML and the second electrode CE, and a capping layer CPL disposed on the second electrode CE.

The first electrode AE may be disposed on the sixth insulating layer INS6. The first electrode AE may be connected to the second connection electrode CNE2 through a third contact hole CH3 passing through the sixth insulating layer INS6. The first electrode AE may be electrically connected to the drain D1 of the transistor TR through the first and second connection electrodes CNE1 and CNE2.

The first electrode AE may be formed of a metal material, a metal alloy, or a conductive compound. The first electrode AE may be an anode or a cathode. However, embodiments of the present disclosure are not limited thereto. In some aspects, the first electrode AE may be a pixel electrode. The first electrode AE may be a transmissive electrode, a transflective electrode, or a reflective electrode. The first electrode AE may include at least one selected from Ag, Mg, Cu, Al, Pt, Pd, Au, Ni, Nd, Ir, Cr, Li, Ca, LiF, Mo, Ti, W, In, Zn, Sn, and Yb, two or more compounds selected from the described materials, a mixture of two or more selected from the described materials, or oxides thereof.

When the first electrode AE is the transmissive electrode, the first electrode AE may include transparent metal oxide, for example, indium tin oxide (ITO), indium zinc oxide (IZO), zinc oxide (ZnO), or indium tin zinc oxide (ITZO). In an example in which the first electrode AE is the transflective electrode or the reflective electrode, the first electrode AE may include Ag, Mg, Cu, Al, Pt, Pd, Au, Ni, Nd, Ir, Cr, Li, Ca, LiF/Ca (laminated structure of LiF and Ca), LiF/Al (laminated structure of LiF and Al), Mo, Ti, W, or a compound or mixture thereof (for example, a mixture of Ag and Mg). Alternatively, the first electrode AE may have a multi-layered structure including a reflective layer or transflective layer and a transparent conductive layer formed of indium tin oxide (ITO), indium zinc oxide (IZO), zinc oxide (ZnO), or indium tin zinc oxide (ITZO). For example, the first electrode AE may include a three-layer structure of ITO/Ag/ITO, but embodiments of the present disclosure are not limited thereto. In some aspects, embodiments of the present disclosure are not limited thereto, and the first electrode AE may include the described metal materials, a combination of two or more metal materials of the described metal materials, or oxides of the described metal materials.

The pixel defining film PDL may be disposed on the sixth insulating layer INS6. A first sub-opening PX_OP1 exposing a portion of the first electrode AE may be defined in the pixel defining film PDL. A portion of the first electrode AE exposed by the first sub-opening PX_OP1 may be defined as an emission area LA. For example, the pixel defining film PDL may include an organic light-blocking material or an inorganic light-blocking material. Each of the organic light-blocking material and the inorganic light-blocking material may include a black pigment and/or a black dye.

The active area DM-AA of the display device DD may include the emission area LA and a light blocking area NLA. An area on which the pixel defining film PDL is disposed may correspond to the light blocking area NLA. The light blocking area NLA may surround the emission area LA within the active area DM-AA.

The hole control layer HCL may be disposed on the first electrode AE and the pixel defining film PDL. The hole control layer HCL may be provided as a common layer overlapping the emission area LA and the light blocking area NLA. The hole control layer HCL may include at least one of a hole transport layer, a hole injection layer, or an electron blocking layer. The hole control layer HCL may include a known hole injection material and/or a known hole transport material.

The emission layer EML may be disposed on the hole control layer HCL. The emission layer EML may overlap the active area DM-AA. The emission layer EML may be disposed on an area corresponding to the first sub-opening PX_OP1. Alternatively, the emission layer EML may be provided as a common layer. The emission layer EML may include an organic light-emitting material and/or an inorganic light-emitting material. The emission layer EML may emit light having any one of red, green, and blue colors.

The electron control layer TCL may be disposed on the emission layer EML. The electron control layer TCL may be provided as a common layer overlapping the emission area LA and the light blocking area NLA. The electron control layer TCL may include at least one of an electron transport layer, an electron injection layer, or a hole blocking layer. The electron control layer TCL may include a known electron injecting material and/or a known electron transport material.

The second electrode CE may be disposed on the electron control layer TCL. The second electrode CE may be provided as a common layer overlapping the emission area LA and the light blocking area NLA.

The second electrode CE may be a common electrode. The second electrode CE may be a cathode or an anode, but the embodiment is not limited thereto. In an example in which the first electrode AE is the anode, the second electrode CE may be the cathode, and when the first electrode AE is the cathode, the second electrode CE may be the anode.

The second electrode CE may be a transmissive electrode, a transflective electrode, or a reflective electrode. In an example in which the second electrode CE is the transmissive electrode, the second electrode CE may be formed of metal oxide, for example, indium tin oxide (ITO), indium zinc oxide (IZO), zinc oxide (ZnO), or indium tin zinc oxide (ITZO).

When the second electrode CE is the transflective electrode or the transmissive electrode, the second electrode CE may include Ag, Mg, Cu, Al, Pt, Pd, Au, Ni, Nd, Ir, Cr, Li, Ca, LiF/Ca, LiF/Al, Mo, Ti, Yb, W, or a compound or mixture thereof (for example, AgMg, AgYb, or MgYb) Alternatively, the second electrode CE may have a multi-layered structure including a reflective layer or transflective layer and a transparent conductive layer formed of indium tin oxide (ITO), indium zinc oxide (IZO), zinc oxide (ZnO), or indium tin zinc oxide (ITZO). For example, the second electrode CE may include the described metal materials, a combination of two or more metal materials of the described metal materials, or oxides of the described metal materials.

The capping layer CPL may be disposed on the second electrode CE. The capping layer CPL may be an organic layer or an inorganic layer. In an example in which the capping layer CPL includes the inorganic material, the inorganic material may include an alkali metal compound such as, for example, LiF, an alkaline earth metal compound such as, for example, MgF₂, silicon oxynitride (SiOₓN_{y}), silicon nitride (SiNₓ), silicon oxide (SiO_{y}), or the like. In an example in which the capping layer CPL includes an organic material, the organic material may include α-NPD, NPB, TPD, m-MTDATA, Alq₃, CuPc, N4,N4,N4',N4'-tetra (biphenyl-4-yl) biphenyl-4,4'-diamine (TPD15), 4,4',4"- Tris (carbazol-9-yl) triphenylamine (TCTA), or the like, or may include acrylate such as, for example, an epoxy resin or methacrylate. However, this is an example, and the material contained in the capping layer CPL is not limited thereto.

The filler FL may be disposed on the display element layer DP-EL. The filler FL may include a thermosetting material. For example, the filler FL may include at least one of a silicone-based material, an epoxy-based material, or an acrylic-based material. The second substrate SUB2 may be disposed on the filler FL. The input sensing part ISP may be disposed on the second substrate SUB2.

The input sensing part ISP may include a first sensing insulating layer IL1, a second sensing insulating layer IL2, and a third sensing insulating layer IL3. The input sensing part ISP may include at least one conductive layer disposed on the sensing insulating layers. The input sensing part ISP may include a first conductive layer CDL1 and a second conductive layer CDL2.

The first sensing insulating layer IL1 may be disposed on the second substrate SUB2. The first sensing insulating layer IL1 may include at least one inorganic insulating layer. The first sensing insulating layer IL1 may be in contact with the second substrate SUB2. Alternatively, the first sensing insulating layer IL1 may be omitted, and in this case, the first conductive layer CDL1 may be in contact with the second substrate SUB2.

The first conductive layer CDL1 may be disposed on the first sensing insulating layer IL1. The first conductive layer CDL1 may include a plurality of first conductive patterns. The plurality of first conductive patterns may be disposed on the first sensing insulating layer IL1. The second sensing insulating layer IL2 may be disposed on the first sensing insulating layer IL1 and cover at least a portion of the first conductive layer CDL1.

The second conductive layer CDL2 may be disposed on the second sensing insulating layer IL2. The second conductive layer CDL2 may include a plurality of second conductive patterns. The plurality of second conductive patterns may be disposed on the second sensing insulating layer IL2. Each of the plurality of second conductive patterns may be connected to the plurality of first conductive patterns through a contact hole defined in the second sensing insulating layer IL2.

Each of the plurality of first conductive patterns of the first conductive layer CDL1 and the plurality of second conductive patterns of the second conductive layer CDL2 may be disposed corresponding to the light blocking area NLA. Each of the plurality of first conductive patterns of the first conductive layer CDL1 and the plurality of second conductive patterns of the second conductive layer CDL2 may correspond to a mesh pattern.

The third sensing insulating layer IL3 may be disposed on the second sensing insulating layer IL2 and may cover the second conductive layer CDL2. Each of the second sensing insulating layer IL2 and the third sensing insulating layer IL3 may include an inorganic insulating layer or an organic insulating layer.

Each of the first conductive layer CDL1 and the second conductive layer CDL2 may include a single-layer structure or a multilayer structure laminated in the third direction DR3. The conductive layers CDL1 and CDL2, each of which has the single-layer structure, may include a conductive metal layer or a transparent conductive layer. The conductive metal layer may include molybdenum, silver, titanium, copper, aluminium, or alloys thereof. The transparent conductive layer may include a transparent conductive oxide such as, for example, indium tin oxide (ITO), indium zinc oxide (IZO), zinc oxide (ZnO), or indium zinc tin oxide (IZTO). In some aspects, the transparent conductive layer may include a conductive polymer such as, for example, PEDOT, a metal nanowire, graphene, or the like.

The multilayer conductive layers CDL1 and CDL2 may include conductive metal layers. The conductive metal layers may include a three-layer structure of, for example, titanium (Ti)/aluminium (Al)/titanium (Ti). The multilayer conductive layers CDL1 and CDL2 may include at least one conductive metal layer and at least one transparent conductive layer.

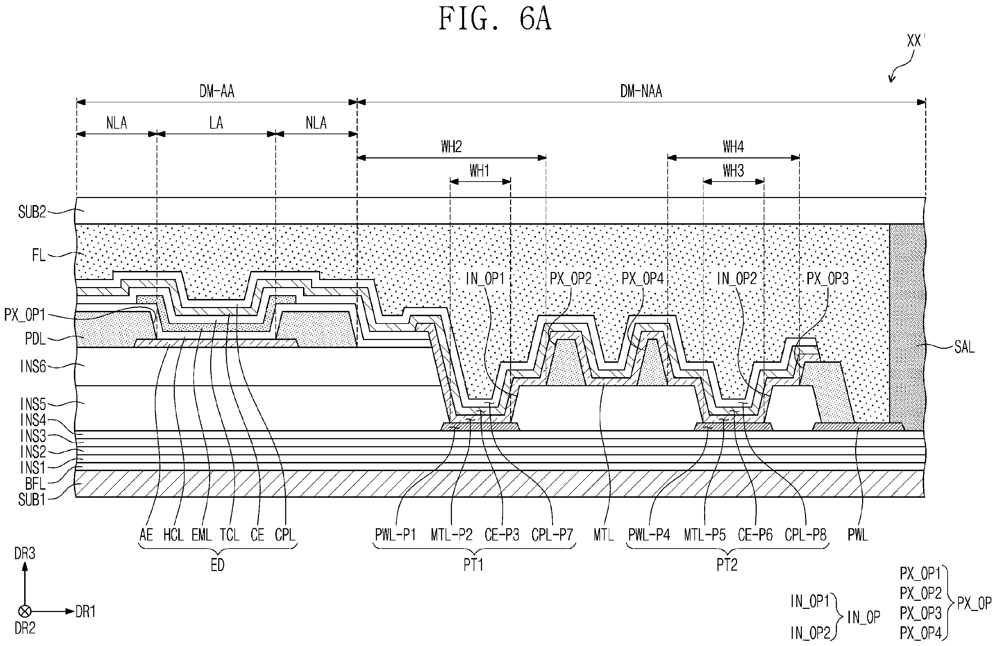

FIG. 6A is an enlarged cross-sectional view of an area XX' of FIG. 3. Referring to FIG. 6A, a first pattern part PT1 and a second pattern part PT2 are disposed on the peripheral area DM-NAA. The first pattern part PT1 and the second pattern part PT2 may include the same pattern. The first pattern part PT1 and the second pattern part PT2 overlap the peripheral area DM-NAA and may not overlap the active area DM-AA. The second pattern part PT2 is spaced apart from the active area DM-AA, with the first pattern part PT1 between the second pattern part PT2 and the active area DM-AA.

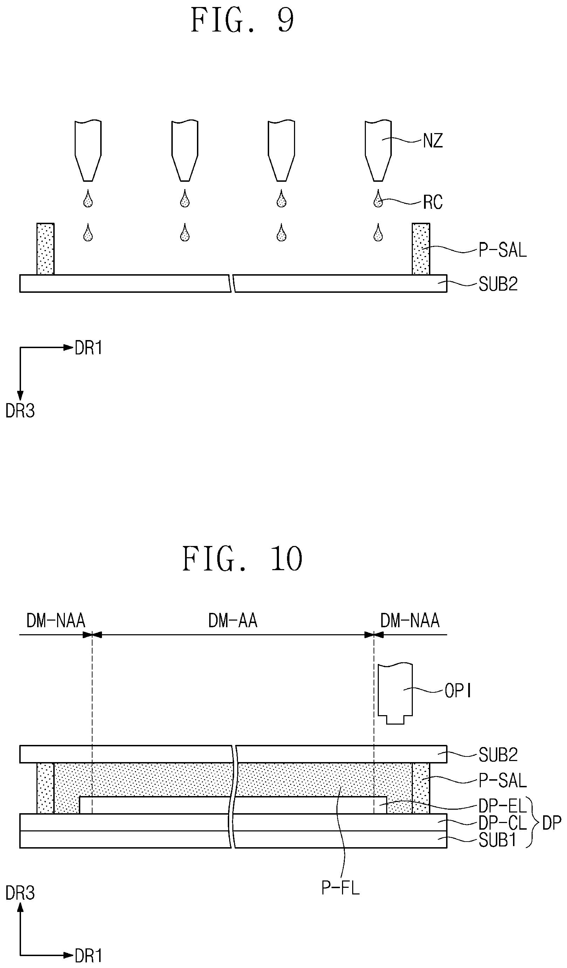

Embodiments of the present disclosure may include forming the filler FL by providing a liquid composition RC (see FIG. 9). Embodiments of the present disclosure may include, after providing a preliminary sealing part P-SAL (see FIG. 9) on the second substrate SUB2 (see FIG. 9), forming a preliminary filler P-FL (see FIG. 10) by providing a composition RC (see FIG. 9). Embodiments of the present disclosure may include, after forming a sealing part SAL from the preliminary sealing part P-SAL (see FIG. 10), forming the filler FL from the preliminary filler P-FL (see FIG. 10). The preliminary filler P-FL (see FIG. 10) may be the composition RC (see FIG. 9) provided on the second substrate SUB2 (see FIG. 10). Before forming the filler FL, the preliminary filler P-FL may be in a liquid state, and spreading may occur in the preliminary filler P-FL (see FIG. 10) such that the preliminary filler P-FL fills a predetermined space. The predetermined space may refer to a space defined by the first substrate SUB1, the second substrate SUB2, and the preliminary sealing part P-SAL (see FIG. 10). The 'spreading' means moving in various directions such as, for example, upward, downward, left, and right directions on the plane. Here, when the spread of the preliminary filler is excessive, and a movement amount of the preliminary filler from the active area to the peripheral area is large, the sealing part disposed on the peripheral area may not bond the first substrate to the second substrate. In some aspects, if sufficient spreading of the preliminary filler is not confirmed, a time associated with spreading of the preliminary filler may increase, which may deteriorate manufacturing efficiency. The display device DD according to an embodiment may exhibit excellent processibility by including the first and second pattern parts PT1 and PT2.

Since the first pattern part PT1 and the second pattern part PT2 include the same pattern, a degree of the spreading of the preliminary filler P-FL (see FIG. 10) may be easily confirmed. Light transmittance between the first pattern part PT1 and the second pattern part PT2 may be compared with each other using equipment used for automated optical inspection (AOI). Embodiments of the present disclosure may include providing the same light to the first pattern part PT1 and the second pattern part PT2, capturing images of the first pattern part PT1 and the second pattern part PT2, and comparing the images. In an example in which the preliminary filler P-FL (see FIG. 10) moves to a position between the first pattern part PT1 and the second pattern part PT2, there may be a difference between the captured image of the first pattern part PT1 and the captured image of the second pattern part PT2. That is, when the preliminary filler P-FL (see FIG. 10) moves up to a position at which the preliminary filler P-FL exists at an upper side of the first pattern part PT1, but does not exist at an upper side of the second pattern part PT2, there may be a difference between the captured image of the first pattern part PT1 and the captured image of the second pattern part PT2 due to the preliminary filler P-FL (see FIG. 10). Due to the preliminary filler P-FL (see FIG. 10), there may be a difference in light transmittance, and the captured images may be different from each other. Thus, the captured images may be compared with each other to easily confirm the degree of the spreading of the preliminary filler P-FL (see FIG. 10), thereby preventing the excessive spreading and reducing the time associated with completing the spreading.

In an embodiment, the first pattern part PT1 includes a first portion PWL-P1 of a line PWL, a second portion MTL-P2 of a metal layer MTL, and a third portion CE-P3 of a second electrode CE. The second pattern part PT2 includes a fourth portion PWL-P4 of the line PWL, a fifth portion MTL-P5 of the metal layer MTL, and a sixth portion CE-P6 of the second electrode CE. For example, the second portion MTL-P2 of the metal layer MTL may be directly disposed between the first portion PWL-P1 of the line PWL and the third portion CE-P3 of the second electrode CE. The fifth portion MTL-P5 of the metal layer MTL may be directly disposed between the fourth portion PWL-P4 of the line PWL and the sixth portion CE-P6 of the second electrode CE.

In some cases, the first portion PWL-P1 of a line PWL, the second portion MTL-P2 of the metal layer MTL, and the third portion CE-P3 of the second electrode CE may respectively be referred to as the first portion of the line PWL, a first portion of the metal layer MTL, and a first portion of the second electrode CE, and the fourth portion PWL-P4 of the line PWL, the fifth portion MTL-P5 of the metal layer MTL, and the sixth portion CE-P6 of the second electrode CE may respectively be referred to as a second portion of the line PWL, a second portion of the metal layer MTL, and a second portion of the second electrode CE.

For one component, the first pattern part PT1 may include one portion, and the second pattern part PT2 may include another portion. Thus, the first pattern part PT1 and the second pattern part PT2 may include the same pattern. The first pattern part PT1 and the second pattern part PT2 include the first portion PWL-P1 of the line PWL and the fourth portion PWL-P4 of the line PWL, respectively. The first pattern part PT1 and the second pattern part PT2 include the second portion MTL-P2 of the metal layer MTL and the fifth portion MTL-P5 of the metal layer MTL, respectively. The first pattern part PT1 and the second pattern part PT2 include the third portion CE-P3 of the second electrode CE and the sixth portion CE-P6 of the second electrode CE, respectively.

In the first direction DR1 perpendicular to the thickness direction DR3, the first pattern part PT1 and the second pattern part PT2 may be spaced apart from each other, with the fifth insulating layer INS5 between the first pattern part PT1 and the second pattern part PT2. The fifth insulating layer INS5 may overlap the active area DM-AA and the peripheral area DM-NAA. As described herein, the fifth insulating layer INS5 may be an organic layer. Unlike that is illustrated, the sixth insulating layer INS6 may be disposed on the fifth insulating layer INS5 on the peripheral area DM-NAA. In this case, in the first direction DR1, the first pattern part PT1 and the second pattern part PT2 may be spaced apart from each other, with the fifth insulating layer INS5 and the sixth insulating layer INS6 between the first pattern part PT1 and the second pattern part PT2.

A plurality of insulating openings IN_OP may be defined in the fifth insulating layer INS5. The plurality of insulating openings IN_OP may include a first auxiliary opening IN_OP1 and a second auxiliary opening IN_OP2. The first pattern part PT1 may be disposed within the first auxiliary opening IN_OP1, and the second pattern part PT2 may be disposed within the second auxiliary opening IN_OP2.

A plurality of openings PX_OP are defined in the pixel defining film PDL. The plurality of openings PX_OP include a first sub-opening PX_OP1, a second sub-opening PX_OP2, and a third sub-opening PX_OP3. In the first direction DR1 perpendicular to the thickness direction DR3, the first sub-opening PX_OP1 and the third sub-opening PX_OP3 may be spaced apart from each other, with the second sub-opening PX_OP2 between the first sub-opening PX_OP1 and the third sub-opening PX_OP3. In the pixel defining film PDL, the first sub-opening PX_OP1 may overlap the active area DM-AA, and the second sub-opening PX_OP2 and the third sub-opening PX_OP3 may overlap the peripheral area DM-NAA. As described herein, a portion of the first electrode AE may be exposed through the first sub-opening PX_OP1.

In some aspects, the plurality of openings PX_OP may further include a fourth sub-opening PX_OP4. The fourth sub-opening PX_OP4 may be defined between the second sub-opening PX_OP2 and the third sub-opening PX_OP3. Unlike that is illustrated, the fourth sub-opening PX_OP4 may be omitted.

The first auxiliary opening IN_OP1 of the fifth insulating layer INS5 may overlap the second sub-opening PX_OP2 of the pixel defining film PDL. In the first direction DR1 perpendicular to the thickness direction DR3, a first width WH1 of the first auxiliary opening IN_OP1 may be less than a second width WH2 of the second sub-opening PX_OP2. The second auxiliary opening IN_OP2 of the fifth insulating layer INS5 may overlap the third sub-opening PX_OP3 of the pixel defining film PDL. In the first direction DR1 perpendicular to the thickness direction DR3, a third width WH3 of the second auxiliary opening IN_OP2 may be less than a fourth width WH4 of the third sub-opening PX_OP3.

The first portion PWL-P1 of the line PWL may be exposed through the first auxiliary opening IN_OP1. The fourth portion PWL-P4 of the line PWL may be exposed through the second auxiliary opening IN_OP2. The line PWL may be disposed on the fourth insulating layer INS4. As described herein, the fourth insulating layer INS4 may include an inorganic material. The fourth insulating layer INS4 may be disposed between the first substrate SUB 1 and the fifth insulating layer INS5.

The line PWL may overlap the peripheral area DM-NAA. The line PWL may not overlap the active area DM-AA. The line PWL may include a three-layer structure of Ti/Al/Ti. The line PWL may be the first power line PL1 or the second power line PL2 illustrated in FIG. 4. The first portion PWL-P1 of the line PWL and the fourth portion PWL-P4 of the line PWL may be spaced apart from each other in the first direction DR1 perpendicular to the thickness direction DR3. In this specification, the fourth insulating layer INS4 may be referred to as a sub-insulating layer.

In the peripheral area DM-NAA, the metal layer MTL may be disposed on the fifth insulating layer INS5 and the line PWL. In the first direction DR1 perpendicular to the thickness direction DR3, the metal layer MTL may be spaced a predetermined interval from the sealing part SAL. The metal layer MTL may overlap the peripheral area DM-NAA. The metal layer MTL may non-overlap the active area DM-AA. In the metal layer MTL, the second portion MTL-P2 and the fifth portion MTL-P5 may be integrated with each other.

The metal layer MTL may include at least one selected from Ag, Mg, Cu, Al, Pt, Pd, Au, Ni, Nd, Ir, Cr, Li, Ca, Mo, Ti, W, In, Zn, Sn, and Yb, two or more compounds selected from the described materials, a mixture of two or more selected from the described materials, or oxides thereof. For example, the compounds include LiF. The metal layer MTL may include the same material as the first electrode AE of the light emitting element ED. The metal layer MTL may be formed at the same process as the first electrode AE of the light emitting element ED. For example, each of the metal layer MTL and the first electrode AE of the light emitting element ED may include a three-layer structure of ITO/Ag/ITO.

In the peripheral area DM-NAA, the second electrode CE may be disposed on the metal layer MTL. In the first direction DR1 perpendicular to the thickness direction DR3, the second electrode CE may be spaced a predetermined interval from the sealing part SAL. The second electrode CE may extend from the active area DM-AA to the peripheral area DM-NAA. The second electrode CE may overlap the active area DM-AA and the peripheral area DM-NAA. In the second electrode CE, the third portion CE-P3 and the sixth portion CE-P6 may be integrated with each other.

In an embodiment, the first pattern part PT1 may further include a seventh portion CPL-P7 of the capping layer CPL. The second pattern part PT2 may further include an eighth portion CPL-P8 of the capping layer CPL.

The capping layer CPL may be disposed on the second electrode CE. In the first direction DR1 perpendicular to the thickness direction DR3, the capping layer CPL may be spaced a predetermined interval from the sealing part SAL. The capping layer CPL may extend from the active area DM-AA to the peripheral area DM-NAA. The capping layer CPL may overlap the active area DM-AA and the peripheral area DM-NAA. In the capping layer CPL, the seventh portion CPL-P7 and the eighth portion CPL-P8 may be integrated with each other.

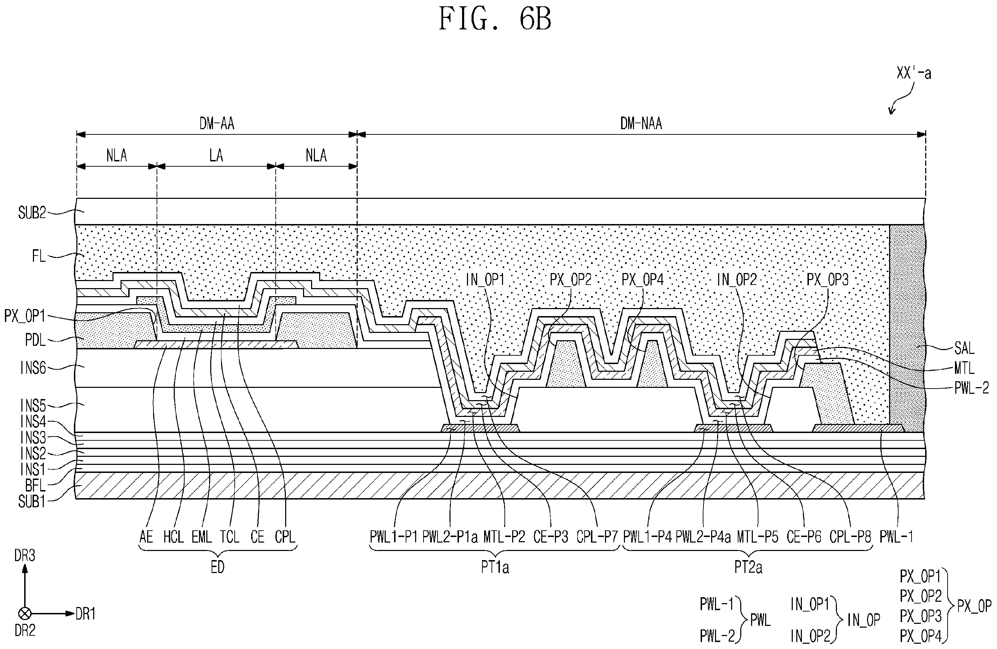

FIG. 6B is an enlarged cross-sectional view of an area XX'-a according to another embodiment of the inventive concept. In descriptions of FIG. 6B, contents duplicated with those described with reference to FIGS. 1 to 6A will not be described again, and differences will be mainly described.

When compared with an XX' area illustrated in FIG. 6A, an XX'-a area illustrated in FIG. 6B is different in that the line PWL includes a first sub-line PWL-1 and a second sub-line PWL-2. If the second sub-line PWL-2 is omitted in FIG. 6B, FIG. 6B may be the same as FIG. 6A.

Referring to FIG. 6B, the first pattern part PT1a may include a ninth portion PWL1-P1 of the first sub-line PWL-1, a tenth portion PWL2-P1a of the second sub-line PWL-2, a second portion MTL-P2 of the metal layer MTL, and a third portion CE-P3 of the second electrode CE. The first pattern part PT1a may further include a seventh portion CPL-P7 of the capping layer CPL. The ninth portion PWL1-P1 of the first sub-line PWL-1 may be the same as the first portion PWL-P1 of the line PWL illustrated in FIG. 6A.

The second pattern part PT2a may include an eleventh portion PWL1-P4 of the first sub-line PWL-1, a twelfth portion PWL2-P4a of the second sub-line PWL-2, a fifth portion MTL-P5 of the metal layer MTL, and a sixth portion CE-P6 of the second electrode CE. The second pattern part PT2a may further include an eighth portion CPL-P8 of the capping layer CPL. The eleventh portion PWL1-P4 of the first sub-line PWL-1 may be the same as the fourth portion PWL-P4 of the line PWL illustrated in FIG. 6A.

In the second sub-line PWL-2, the tenth portion PWL2-P1a and the twelfth portion PWL2-P4a may be integrated with each other. Alternatively, the tenth portion PWL2-P1a and the twelfth portion PWL2-P4a may be disposed spaced apart from each other in the first direction DR1 perpendicular to the thickness direction DR3. In this case, the tenth portion PWL2-P1a and the twelfth portion PWL2-P4a may be spaced apart from each other in the first direction DR1, with the fifth insulating layer INS5 between the tenth portion PWL2-P1a and the twelfth portion PWL2-P4a.

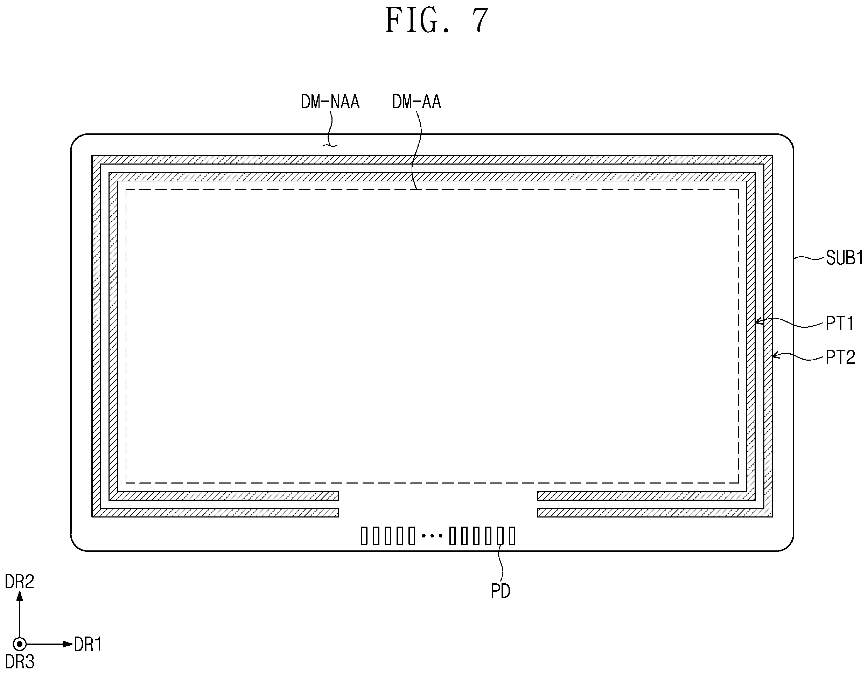

FIG. 7 is a schematic plan view illustrating a partial configuration of the display device DD (see FIG. 2) for convenience of explanation. Referring to FIG. 7, the first pattern part PT1 and the second pattern part PT2 may be disposed such that each of the first pattern part PT1 and the second pattern part PT2 surrounds a portion of the active area DM-AA. On the plane perpendicular to the thickness direction DR3, at least a portion of each of the first pattern part PT1 and the second pattern part PT2 may be spaced apart from the pads PD. On the plane, at least a portion of each of the first pattern part PT1 and the second pattern part PT2 may be spaced a predetermined interval from the pads PD. In an example case in which the first and second pattern parts are provided in a closed ring shape that surrounds the entire active area, signal lines such as, for example, the control lines SL-C1 and SL-C2 illustrated in FIG. 4 may not be connected to the pads PD. In an example case in which the first and second pattern parts are provided in the closed ring shape that surrounds the entire active area, there may be no space for the signal lines to be connected to the pads. Alternatively, in an embodiment, the first pattern part PT1 and the second pattern part PT2 may be disposed such that each of the first pattern part PT1 and the second pattern part PT2 surrounds a portion (e.g., only a portion) of the active area DM-AA, and thus, the signal lines may be easily connected to the pads PD.

In the first pattern parts PT1 and PT1a, the second portion MTL-P2 of the metal layer MTL and the third portion CE-P3 of the second electrode CE illustrated in FIGS. 6A and 6B may be spaced apart from the pads PD on the plane. In some aspects, in the first pattern parts PT1 and PT1a, the seventh portion CPL-P7 of the capping layer CPL illustrated in FIGS. 6A and 6B may be spaced apart from the pads PD on the plane.

In the second pattern parts PT2 and PT2a, the fifth portion MTL-P5 of the metal layer MTL and the sixth portion CE-P6 of the second electrode CE illustrated in FIGS. 6A and 6B may be spaced apart from the pads PD. In some aspects, in the second pattern parts PT2 and PT2a, the eighth portion CPL-P8 of the capping layer CPL illustrated in FIGS. 6A and 6B may be spaced apart from the pads PD on the plane.

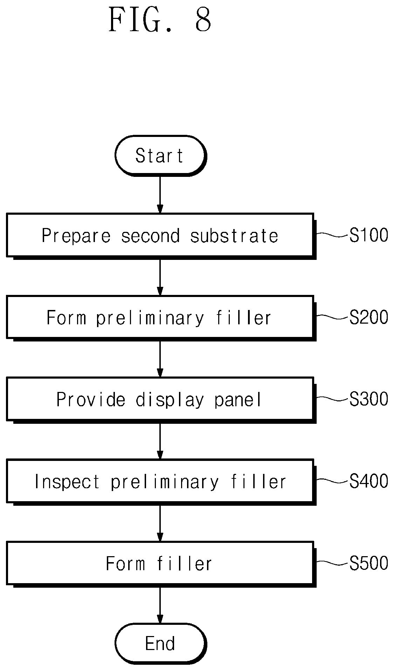

The display device according to an embodiment may be manufactured by a method for manufacturing the display device according to an embodiment. FIG. 8 is a flowchart illustrating a method for manufacturing a display device according to an embodiment of the inventive concept. FIGS. 9 to 12 are schematic views illustrating a method for manufacturing the display device according to an embodiment of the inventive concept. In following descriptions of FIGS. 8 to 12, content that overlaps the content described with reference to FIGS. 1 to 7 will not be described again, and differences will be mainly explained.

In the descriptions of the method and processes herein, the operations may be performed in a different order than the order shown and/or described, or the operations may be performed in different orders or at different times. Certain operations may also be left out of the flowcharts, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

Referring to FIG. 8, a method for manufacturing the display device according to an embodiment includes a step (S100) of preparing a second substrate, a step (S200) of forming a preliminary filler, a step (S300) of providing a display panel, a step (S400) of inspecting the preliminary filler, and a step (S500) of forming a filler.

Referring to FIG. 9, the method may include providing a liquid composition RC on one surface of the second substrate SUB2. Embodiments of the present disclosure may include providing, by a dispensing method, the composition RC in association with forming a preliminary filler P-FL (see FIG. 10). In FIG. 9, the composition RC is illustrated as being provided through a nozzle NZ, but a device for providing the composition RC is not limited thereto.

The method for manufacturing the display device DD (see FIG. 2) according to an embodiment may further include a step of providing a preliminary sealing part P-SAL before the step of forming the preliminary filler P-FL (see FIG. 10). That is, before providing the composition RC, the method may include forming the preliminary sealing part P-SAL on an area of the second substrate SUB2. The preliminary sealing part P-SAL may be formed on an area of the second substrate SUB2 which overlaps a peripheral area DM-NAA (see FIG. 10).

Referring to FIG. 10, the method includes providing a display panel DP on the preliminary filler P-FL. Thereafter, the method may include using a photographing device OPI (also referred to herein as an image capture device) to inspect the preliminary filler P-FL. The photographing device OPI may be a device capable of capturing images of first pattern parts PT1 and PT1a (see FIGS. 6A and 6B) and second pattern parts PT2 and PT2a (see FIGS. 6A and 6B).

The display panel DP includes the first pattern parts PT1 and PT1a (see FIGS. 6A and 6B) and the second pattern parts PT2 and PT2a (see FIGS. 6A and 6B). As described herein, the first pattern parts PT1 and PT1a and the second pattern parts PT2 and PT2a may include the same pattern.

In order to inspect a degree of spreading of the preliminary filler P-FL, the method may include capturing images of the first pattern parts PT1 and PT1a (see FIGS. 6A and 6B) and the second pattern parts PT2 and PT2a (see FIGS. 6A and 6B) using the photographing device OPI. An automatic optical inspection device may be used to capture images of the first pattern parts PT1 and PT1a (see FIGS. 6A and 6B) and the second pattern parts PT2 and PT2a (see FIGS. 6A and 6B), in which the same light is provided to the first pattern parts PT1 and PT1a (see FIGS. 6A and 6B) and the second pattern parts PT2 and PT2a (see FIGS. 6A and 6B). Images captured in a state in which a distal end of the preliminary filler P-FL is disposed between the first pattern parts PT1 and PT1a (see FIGS. 6A and 6B) and the second pattern parts PT2 and PT2a (see FIGS. 6A and 6B) on the plane may be different from each other. There may be a difference in light transmittance due to the preliminary filler P-FL, and the method may include confirming this difference based on the captured images. The captured images of the first pattern parts PT1 and PT1a (see FIGS. 6A and 6B) and the captured images of the second pattern parts PT2 and PT2a (see FIGS. 6A and 6B) may appear differently depending on the difference in light transmittance.

Alternatively, when the distal end of the preliminary filler P-FL is disposed between the second pattern parts PT2 and PT2a (see FIGS. 6A and 6B) and the preliminary sealing part P-SAL on the plane, the captured images may be substantially the same. In this case, since there is practically no difference in light transmittance, the captured images of the first pattern parts PT1 and PT1a (see FIGS. 6A and 6B) and the captured images of the second pattern parts PT2 and PT2a (see FIGS. 6A and 6B) may be substantially the same.

When the distal end of the preliminary filler P-FL is disposed within the active area DM-AA, the captured images may be compared by capturing the same pixels PX (see FIG. 4). Since the pixels PX (see FIG. 4) having the same color contain the same configuration, the method may include capturing images of the pixels PX and comparing the captured images, thereby confirming the position of the distal end of the preliminary filler P-FL.

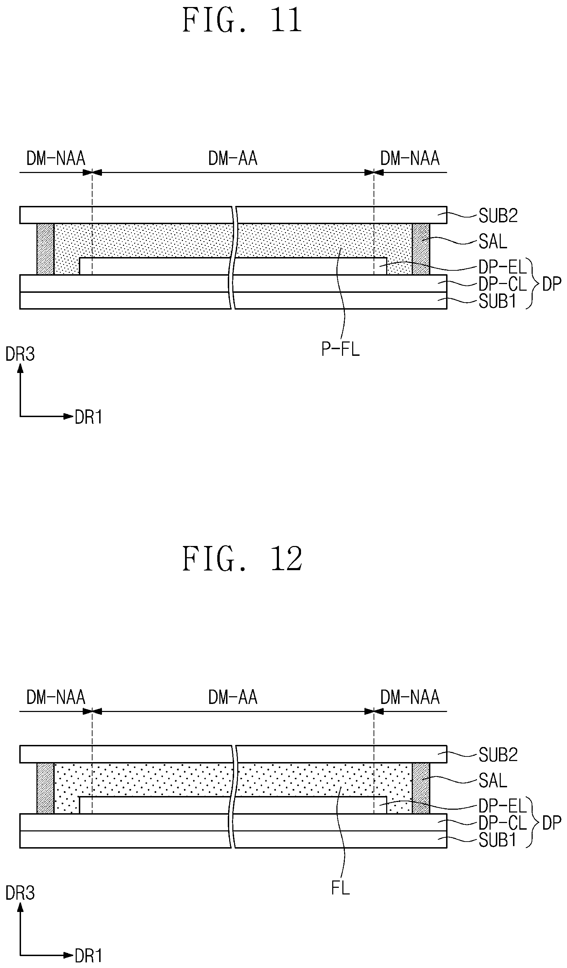

After inspecting the preliminary filler P-FL, the method may include forming a sealing part SAL from the preliminary sealing part P-SAL, as illustrated in FIG. 11. The sealing part SAL may be formed by emitting a laser such that the preliminary sealing part P-SAL is irradiated with the laser. The first substrate SUB1 and the second substrate SUB2 may be bonded by the sealing part SAL. The display panel DP and the second substrate SUB2 may be bonded by the sealing part SAL. Subsequently, a filler FL illustrated in FIG. 12 may be formed from the preliminary filler P-FL. The method may include forming the filler FL by thermally curing the preliminary filler P-FL.

The display device according to an embodiment may include the second substrate disposed on the first substrate, which is distinguished by the peripheral area adjacent to the active area, and the filler that fills an internal space between the first substrate and the second substrate, and the display device according to an embodiment includes the first pattern part and the second pattern part overlapping the peripheral area. The first and second pattern parts may have the same pattern. The first pattern part includes a first portion of a line, a second portion of a metal layer, and a third portion of a second electrode. The second pattern part includes a fourth portion of the line, a fifth portion of the metal layer, and a sixth portion of the second electrode. Thus, the display device according to an embodiment may exhibit excellent processibility.

The display device according to an embodiment may be manufactured by a method for manufacturing the display device according to an embodiment. The method for manufacturing the display device according to an embodiment includes a step of inspecting the preliminary filler and a step of forming the filler from the preliminary filler. The step of inspecting the preliminary filler includes comparing light transmittance of the first pattern part and light transmittance of the second pattern part with each other. Thus, the method for manufacturing the display device according to an embodiment may exhibit excellent manufacturing efficiency.

The display device and the electronic apparatus including the same include the first and second pattern parts described herein, which may provide the excellent processibility.

The method for manufacturing the display device includes the process of comparing the light transmittance of the first pattern part with the light transmittance of the second pattern part, and thus the method may exhibit the excellent manufacturing efficiency.

It will be apparent to those skilled in the art that various modifications and variations can be made in the inventive concept. Thus, it is intended that the present disclosure covers the modifications and variations of this invention provided they come within the scope of the appended claims and their equivalents.

Hence, the real protective scope of the inventive concept shall be determined by the technical scope of the accompanying claims.

Embodiments are set out in the following clauses:
Clause 1. A display device comprising:
   a first substrate that is divided into an active area and a peripheral area adjacent to the active area;
   an insulating layer overlapping the active area and the peripheral area and disposed on the first substrate;
   a line overlapping the peripheral area and disposed on the first substrate;
   a pixel defining film in which a plurality of opening comprising first to third sub-openings are defined and which is disposed on the insulating layer;
   a first electrode exposed through the first sub-opening, overlapping the active area, and disposed on the insulating layer;
   a second electrode extending from the active area to the peripheral area and disposed on the first electrode;
   an emission layer overlapping the active area and disposed between the first electrode and the second electrode;
   a metal layer exposed through the second sub-opening and the third sub-opening, overlapping the peripheral area, and disposed on the insulating layer;
   a first pattern part comprising a first portion of the line, a second portion of the metal layer, and a third portion of the second electrode and overlapping the peripheral area; and
   a second pattern part comprising a fourth portion of the line, a fifth portion of the metal layer, and a sixth portion of the second electrode and spaced apart from the active area with the first pattern part therebetween.
Clause 2. The display device of clause 1, further comprising:
   a second substrate disposed on the pixel defining film;
   a sealing part disposed between the first substrate and the second substrate and overlapping the peripheral area; and
   a filler configured to be filled into an internal space defined by the first substrate, the second substrate, and the sealing part.
Clause 3. The display device of clause 1 or clause 2, wherein the display device further comprises a capping layer extending from the active area to the peripheral area and disposed on the second electrode,
   wherein the first pattern part further comprises a seventh portion of the capping layer, and
   the second pattern part further comprises an eighth portion of the capping layer.
Clause 4. The display device of any one of clauses 1 to 3, wherein, in one direction perpendicular to a thickness direction, the first pattern part and the second pattern part are spaced apart from each other with the insulating layer therebetween.
Clause 5. The display device of any one of clauses 1 to 4, wherein the line comprises a first sub-line and a second sub-line disposed on the first sub-line.
Clause 6. The display device of any one of clauses 1 to 5, wherein a plurality of insulating openings comprising a first auxiliary opening and a second auxiliary opening are defined in the insulating layer,
   wherein the first pattern part is disposed within the first auxiliary opening, and the second pattern part is disposed within the second auxiliary opening.
Clause 7. The display device of clause 6, wherein the first auxiliary opening of the insulating layer overlaps the second sub-opening of the pixel defining film, and in one direction perpendicular to a thickness direction, a first width of the first auxiliary opening is less than a second width of the second sub-opening.
Clause 8. The display device of clause 6 or clause 7, wherein the second auxiliary opening of the insulating layer overlaps the third sub-opening of the pixel defining film, and
   in one direction perpendicular to a thickness direction, a third width of the second auxiliary opening is less than a fourth width of the third sub-opening.
Clause 9. The display device of any one of clauses 1 to 8, wherein the insulating layer comprises an organic material.
Clause 10. The display device of any one of clauses 1 to 9, wherein the first electrode and the metal layer comprise the same material.
Clause 11. The display device of any one of clauses 1 to 10, wherein the metal layer comprises at least one selected from g, Mg, Cu, Al, Pt, Pd, Au, Ni, Nd, Ir, Cr, Li, Ca, Mo, Ti, W, In, Zn, Sn, and Yb, two or more compounds selected from the above-described materials, a mixture of two or more selected from the above-described materials, or oxides thereof.
Clause 12. The display device of any one of clauses 1 to 11, further comprising a pad electrically connected to the line and overlapping the peripheral area.
Clause 13. The display device of clause 12, wherein, on a plane perpendicular to a thickness direction, at least a portion of each of the first pattern part and the second pattern part is spaced apart from the pad.
Clause 14. The display device of any one of clauses 1 to 13, further comprising a sub-insulating layer disposed between the first substrate and the insulating layer, wherein the sub-insulating layer comprises an inorganic material.
Clause 15. The display device of clause 14, wherein the line is disposed on the sub-insulating layer.
Clause 16. The display device of any one of clauses 1 to 15, wherein, on a plane perpendicular to a thickness direction, each of the first pattern part and the second pattern part is disposed to surround a portion of the active area.
Clause 17. A method for manufacturing a display device, the method comprising: preparing a second substrate;
   providing a composition onto the second substrate to form a preliminary filler;
   providing a display panel on the preliminary filler;
   inspecting the preliminary filler; and
   curing the preliminary filler to form a filler,
   wherein the display panel comprises:
      a first substrate that is divided into an active area and a peripheral area adjacent to the active area;
      an insulating layer overlapping the active area and the peripheral area and disposed on the first substrate;
      a line overlapping the peripheral area and disposed on the first substrate;
      a pixel defining film in which a plurality of opening comprising first to third sub-openings are defined and which is disposed on the insulating layer;
      a first electrode exposed through the first sub-opening, overlapping the active area, and disposed on the insulating layer;
      a second electrode extending from the active area to the peripheral area and disposed on the first electrode;
      an emission layer overlapping the active area and disposed between the first electrode and the second electrode;
      a metal layer exposed through the second sub-opening and the third sub-opening, overlapping the peripheral area, and disposed on the insulating layer;
      a first pattern part comprising a first portion of the line, a second portion of the metal layer, and a third portion of the second electrode and overlapping the peripheral area; and
      a second pattern part comprising a fourth portion of the line, a fifth portion of the metal layer, and a sixth portion of the second electrode and spaced apart from the active area with the first pattern part therebetween,
      wherein, in the inspecting of the preliminary filler, light transmittance of the first pattern part and light transmittance of the second pattern part are compared with each other.
Clause 18. The method of clause 17, wherein the composition is provided in a dispensing method.
Clause 19. The method of clause 17 or clause 18, further comprising, before the forming of the preliminary filler, providing a preliminary sealing part on one area of the second substrate, which overlaps the peripheral area,
   wherein forming a sealing part from the preliminary sealing part is further performed between the providing of the display panel and the forming of the filler.
Clause 20. The method of clause 19, wherein the filler is filled into an internal space defined by the first substrate, the second substrate, and the sealing part.
Clause 21. The method of any one of clauses 17 to 20, wherein the first electrode and the metal layer comprise the same material.
Clause 22. The method of any one of clauses 17 to 21, wherein the metal layer comprises at least one selected from g, Mg, Cu, Al, Pt, Pd, Au, Ni, Nd, Ir, Cr, Li, Ca, Mo, Ti, W, In, Zn, Sn, and Yb, two or more compounds selected from the above-described materials, a mixture of two or more selected from the above-described materials, or oxides thereof.
Clause 23. An electronic apparatus comprising:
   a display device, on which a sensing area is defined; and
   an electronic module disposed to correspond to the sensing area,
   wherein the display device comprises:
      a first substrate that is divided into an active area and a peripheral area adjacent to the active area;
      an insulating layer overlapping the active area and the peripheral area and disposed on the first substrate;
      a line overlapping the peripheral area and disposed on the first substrate;
      a pixel defining film in which a plurality of opening comprising first to third sub-openings are defined and which is disposed on the insulating layer;
      a first electrode exposed through the first sub-opening, overlapping the active area, and disposed on the insulating layer;
      a second electrode extending from the active area to the peripheral area and disposed on the first electrode;
      an emission layer overlapping the active area and disposed between the first electrode and the second electrode;
      a metal layer exposed through the second sub-opening and the third sub-opening, overlapping the peripheral area, and disposed on the insulating layer;
      a first pattern part comprising a first portion of the line, a second portion of the metal layer, and a third portion of the second electrode and overlapping the peripheral area; and
      a second pattern part comprising a fourth portion of the line, a fifth portion of the metal layer, and a sixth portion of the second electrode and spaced apart from the active area with the first pattern part therebetween.
Clause 24. The electronic apparatus of clause 23, wherein the display device further comprises:
   a second substrate disposed on the pixel defining film;
   a sealing part disposed between the first substrate and the second substrate and overlapping the peripheral area; and
   a filler configured to be filled into an internal space defined by the first substrate, the second substrate, and the sealing part.
Clause 25. The electronic apparatus of clause 23 or clause 24, wherein the display device further comprises a capping layer extending from the active area to the peripheral area and disposed on the second electrode,
   wherein the first pattern part further comprises a seventh portion of the capping layer, and
   the second pattern part further comprises an eighth portion of the capping layer.
Clause 26. The electronic apparatus of any one of clauses 23 to 25, wherein, in one direction perpendicular to a thickness direction, the first pattern part and the second pattern part are spaced apart from each other with the insulating layer therebetween.
Clause 27. The electronic apparatus of any one of clauses 23 to 26, wherein the first electrode and the metal layer comprise the same material.

## Claims

1. A display device (DD) comprising:
a first substrate (SUB1) that is divided into an active area (DM-AA) and a peripheral area (DM-NAA) adjacent to the active area (DM-AA);
an insulating layer (INS5) overlapping the active area (DM-AA) and the peripheral area (DM-NAA) and disposed on the first substrate (SUB1);
a line (PWL) overlapping the peripheral area (DM-NAA) and disposed on the first substrate (SUB1);
a pixel defining film (PDL) in which a plurality of openings (PX_OP) comprising a first sub-opening (PX_OP1), a second sub-opening (PX_OP2), and a third sub-opening (PX_OP3) are defined and which is disposed on the insulating layer (INS5);
a first electrode (AE) exposed through the first sub-opening (PX_OP1), overlapping the active area (DM-AA), and disposed on the insulating layer (INS5);
a second electrode (CE) extending from the active area (DM-AA) to the peripheral area (DM-NAA) and disposed on the first electrode (AE);
an emission layer (EML) overlapping the active area (DM-AA) and disposed between the first electrode (AE) and the second electrode (CE);
a metal layer (MTL) exposed through the second sub-opening (PX_OP2) and the third sub-opening (PX_OP3), overlapping the peripheral area (DM-NAA), and disposed on the insulating layer (INS5);
a first pattern part (PT1) comprising a first portion (PWL-P1) of the line (PWL), a second portion (MTL-P2) of the metal layer (MTL), and a third portion (CE-P3) of the second electrode (CE) and overlapping the peripheral area (DM-NAA); and
a second pattern part (PT2) comprising a fourth portion (PWL-P4) of the line (PWL), a fifth portion (MTL-P5) of the metal layer (MTL), and a sixth portion (CE-P6) of the second electrode (CE) and spaced apart from the active area (DM-AA), wherein the first pattern part (PT1) is between the active area (DM-AA) and each of the fourth portion (PWL-P4) of the line (PWL), the fifth portion (MTL-P5) of the metal layer (MTL), and the sixth portion (CE-P6) of the second electrode (CE).

2. The display device (DD) of claim 1, further comprising:
a second substrate (SUB2) disposed on the pixel defining film (PDL);
a sealing part (SAL) disposed between the first substrate (SUB1) and the second substrate (SUB2) and overlapping the peripheral area (DM-NAA); and
a filler (FL) configured to fill an internal space defined by the first substrate (SUB1), the second substrate (SUB2), and the sealing part (SAL).

3. The display device (DD) of claim 1 or claim 2, wherein:
the display device (DD) further comprises a capping layer (CPL) extending from the active area (DM-AA) to the peripheral area (DM-NAA) and disposed on the second electrode (CE),
the first pattern part (PT1) further comprises a seventh portion (CPL-P7) of the capping layer (CPL), and
the second pattern part (PT2) further comprises an eighth portion (CPL-P8) of the capping layer (CPL).

4. The display device (DD) of any one of claims 1 to 3, wherein, in a direction (DR1) perpendicular to a thickness direction (DR3), the first pattern part (PT1) and the second pattern part (PT2) are spaced apart from each other, and the insulating layer (INS5) is between the first pattern part (PT1) and the second pattern part (PT2).

5. The display device (DD) of any one of claims 1 to 4, wherein:
a plurality of insulating openings (IN_OP) comprising a first auxiliary opening (IN_OP1) and a second auxiliary opening (IN_OP2) are defined in the insulating layer (INS5),
the first pattern part (PT1) is disposed within the first auxiliary opening (IN_OP1), and
the second pattern part (PT2) is disposed within the second auxiliary opening (IN_OP2).

6. The display device (DD) of claim 5, wherein:
(i) the first auxiliary opening (IN_OP1) of the insulating layer (INS5) overlaps the second sub-opening (PX_O2) of the pixel defining film (PDL), and
in a direction (DR1) perpendicular to a thickness direction (DR3), a first width (WH1) of the first auxiliary opening (IN_OP1) is less than a second width (WH2) of the second sub-opening (PX_OP2); and/or(ii) the second auxiliary opening (IN_OP2) of the insulating layer (INS5) overlaps the third sub-opening (PX_OP3) of the pixel defining film (PDL), and
in a direction (DR1) perpendicular to a thickness direction (DR3), a third width (WH3) of the second auxiliary opening (IN_OP2) is less than a fourth width (WH4) of the third sub-opening (PX_OP3).

7. The display device (DD) of any one of claims 1 to 6, wherein the insulating layer (INS5) comprises an organic material.

8. The display device (DD) of any one of claims 1 to 7, wherein:
(i) the first electrode (AE) and the metal layer (MTL) comprise the same material; and/or
(ii) the metal layer (MTL) comprises:
at least one selected from materials comprising Ag, Mg, Cu, Al, Pt, Pd, Au, Ni, Nd, Ir, Cr, Li, Ca, Mo, Ti, W, In, Zn, Sn, and Yb,
two or more compounds selected from the materials,
a mixture of two or more selected from the materials, or
at least one selected from oxides of the materials.

9. The display device (DD) of any one of claims 1 to 8, further comprising a pad (PD) electrically connected to the line (PWL) and overlapping the peripheral area (DM-NAA), optionally wherein, on a plane perpendicular to a thickness direction (DR3), at least a portion of each of the first pattern part (PT1) and the second pattern part (PT2) is spaced apart from the pad (PD).

10. The display device (DD) of any one of claims 1 to 9, further comprising a sub-insulating layer (INS4) disposed between the first substrate (SUB1) and the insulating layer (INS5),
wherein the sub-insulating layer (INS4) comprises an inorganic material, optionally wherein the line (PWL) is disposed on the sub-insulating layer (INS4).

11. The display device of any one of claims 1 to 10, wherein, on a plane perpendicular to a thickness direction (DR3), each of the first pattern part (PT1) and the second pattern part (PT2) is disposed surrounding a portion of the active area (DM-AA).

12. A method for manufacturing a display device (DD), the method comprising:
preparing a second substrate (SUB2);
forming a preliminary filler (P-FL) by providing a composition (RC) onto the second substrate (SUB2);
providing a display panel (DP) on the preliminary filler (P-FL);
inspecting the preliminary filler (P-FL); and
forming a filler (FL) by curing the preliminary filler (P-FL),
wherein the display panel (DP) comprises:
a first substrate (SUB1) that is divided into an active area (DM-AA) and a peripheral area (DM-NAA) adjacent to the active area (DM-AA);
an insulating layer (INS5) overlapping the active area (DM-AA) and the peripheral area (DM-NAA) and disposed on the first substrate (SUB1);
a line (PWL) overlapping the peripheral area (DM-NAA) and disposed on the first substrate (SUB1);
a pixel defining film (PDL) in which a plurality of openings (PX_OP) comprising a first sub-opening (PX_OP1), a second sub-opening (PX_OP2), and a third sub-opening (PX_OP3) are defined and which is disposed on the insulating layer (INS5);
a first electrode (AE) exposed through the first sub-opening (PX_OP1), overlapping the active area (DM-AA), and disposed on the insulating layer (INS5);
a second electrode (CE) extending from the active area (DM-AA) to the peripheral area (DM-NAA) and disposed on the first electrode (AE);
an emission layer (EML) overlapping the active area (DM-AA) and disposed between the first electrode (AE) and the second electrode (CE);
a metal layer (MTL) exposed through the second sub-opening (PX_OP2) and the third sub-opening (PX_OP3), overlapping the peripheral area (DM-AA), and disposed on the insulating layer (INS5);
a first pattern part (PT1) comprising a first portion (PWL-P1) of the line (PWL), a second portion (MTL-P2) of the metal layer (MTL), and a third portion (CE-P3) of the second electrode (CE) and overlapping the peripheral area (DM-NAA); and
a second pattern part (PT2) comprising a fourth portion (PWL-P4) of the line (PWL), a fifth portion (MTL-P5) of the metal layer (MTL), and a sixth portion (CE-P6) of the second electrode (CE) and spaced apart from the active area (DM-AA), wherein the first pattern part (PT1) is between the active area (DM-AA) and each of the fourth portion (PWL-P4) of the line (PWL), the fifth portion (MTL-P5) of the metal layer (MTL), and the sixth portion (CE-P6) of the second electrode (CE),
wherein the inspecting of the preliminary filler (P-FL) comprises comparing light transmittance of the first pattern part (PT1) and light transmittance of the second pattern part (PT2) with each other.

13. The method of claim 12, wherein the composition (RC) is provided in a dispensing method.

14. The method of claim 12 or claim 13, further comprising:
before the forming of the preliminary filler (P-FL), providing a preliminary sealing part (P-SAL) on an area of the second substrate (SUB2) which overlaps the peripheral area (DM-AA), and
forming a sealing part (SAL) from the preliminary sealing part (P-SAL), wherein forming the sealing part (SAL) from the preliminary sealing part (P-SAL) is performed between the providing of the display panel (DP) and the forming of the filler (FL), optionally wherein the filler (FL) fills an internal space defined by the first substrate (SUB1), the second substrate (SUB2), and the sealing part (SAL).

15. An electronic apparatus (EA) comprising:
a display device (DD), on which a sensing area (DM-SA) is defined; and
an electronic module (ELM) disposed corresponding to the sensing area (DM-SA),
wherein the display device (DD) is the display device (DD) according to any one of claims 1 to 11.
